# EUROPEAN PATENT APPLICATION

(11) **EP 4 841 659 A1**
(43) Date of publication of application: **18.11.2026**
(21) Application number: 26178539.8
(22) Date of filing: 13.05.2026
(51) Int. Cl.: H01F 6/06, H01F 6/02

(54) **SUPERCONDUCTING MAGNET DEVICE**

(30) Priority: 13.05.2025 JP 2025080230; 19.11.2025 JP 2025198314
(71) Applicant: RIKEN, Wako-shi, Saitama 351-0198 (JP); Jeol Ltd., Akishima, Tokyo 196-8558 (JP)
(72) Inventor: YANAGISAWA, Yoshinori, Tokyo, 196-8558 (JP); SUETOMI, Yu, Saitama, 351-0198 (JP); YAMAZAKI, Toshio, Saitama, 351-0198 (JP); HAMADA, Mamoru, Hyogo, 651-2271 (JP)
(74) Representative: Boult Wade Tennant LLP

(57) **Abstract**

A superconducting magnet device includes a plurality of sections connected in series with each other. The plurality of sections each includes a coil portion and a shunt circuit connected in parallel. The coil portion includes a superconducting coil. The plurality of sections includes one or more low-temperature superconductor (LTS) sections each including an LTS main coil as the superconducting coil; and a high-temperature superconductor (HTS) section including, as the superconducting coil, an HTS main coil and a combination coil connected in series with each other. The combination coil is an LTS sub-coil generating a magnetic field for correcting a magnetic field generated by at least one of the HTS main coil and the LTS main coil. A specific LTS main coil as the LTS main coil is arranged between the HTS main coil on an inner side and the combination coil on an outer side in a radial direction.

## Description

### BACKGROUND OF THE INVENTION

### 1. Field of the Invention

The present invention relates to a superconducting magnet device that includes a high-temperature superconductor (HTS) coil made of HTS and a low-temperature superconductor (LTS) coil made of LTS.

### 2. Description of the Related Art

A superconducting magnet device can generate a strong magnetic field by flowing a large current with low loss. For example, such a superconducting magnet device is used in nuclear magnetic resonance (NMR), magnetic resonance imaging (MRI), a magnet for physical experiments, an accelerator, a linear railway, a nuclear fusion reactor, a motor, an electric generator, a silicon single-crystal pulling apparatus, an aluminum melting apparatus, or the like.

When a plurality of superconducting coils that constitute the superconducting magnet device are energized, particularly as the flowing current increases, the following may occur: the coils are damaged by an electromagnetic stress load; or quench (transition from a superconducting state to a normal conducting state) is caused by a current that exceeds a superconducting critical current, and as a result, the coils are burned due to the temperature increase caused by Joule heat or the arc discharge caused by high voltage. Especially, when a high-temperature superconductor (HTS) coil quenches, the HTS coil tends to be burned due to the localized heat generation, and thus, the suppression of the current increase in the HTS coil is considered as an important problem to be solved.

### [Citation List]

### [Non-Patent Literature]

Non-Patent Literature 1: R. Piao et al. IEEE Transactions on Applied Superconductivity, vol. 29, no. 5, 2019

### SUMMARY OF THE INVENTION

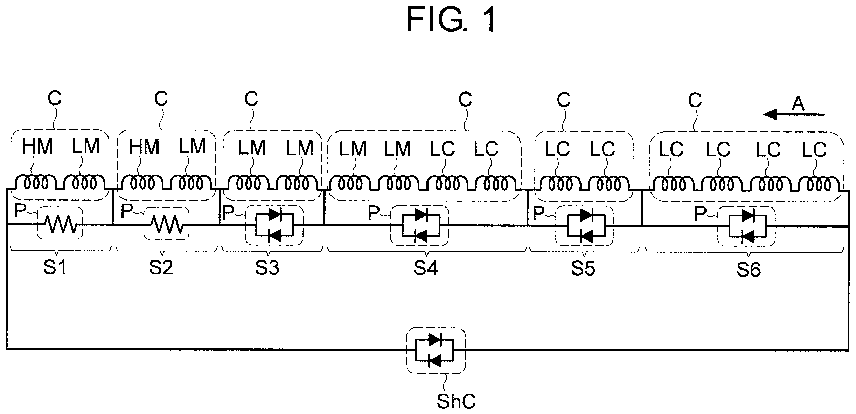

FIG. 1 is a circuit diagram illustrating a superconducting magnet device disclosed in Non-Patent Literature 1. In Non-Patent Literature 1, in FIG. 1, the superconducting magnet device includes a plurality of sections S connected in series with each other. Each of the sections S includes a coil portion C and a shunt circuit P. The coil portion C includes superconducting coils HM, LM, LC, and the shunt circuit P is connected in parallel with the coil portion C.

In FIG. 1, "HM" indicates a main coil made of a high-temperature superconductor, "LM" indicates a main coil made of a low-temperature superconductor, and "LC" indicates a correction coil made of a low-temperature superconductor. Each of the main coils HM and LM mainly generates a strong magnetic field in an internal space, and the correction coil LC mainly generates a magnetic field for increasing the uniformity of the magnetic field in the internal space.

The superconducting coils HM, LM, and LC constituting the superconducting magnet device are coaxially provided in a three-dimensional positional arrangement although they are not illustrated, and the plurality of main coils HM, the plurality of main coils LM, and the plurality of correction coils LC are arranged in this order from the radial-direction inner side to the radial-direction outer side (in detail, see Non-Patent Literature 1). It is assumed that a current flows through a plurality of sections S1 to S6 in a constant direction (a direction of the arrow A in FIG. 1) during steady operation. Hereinafter, the sections S1 to S6 are also simply referred to as the sections S.

According to Non-Patent Literature 1, when quench occurs in the coil LM or LC of any one of the sections S (hereinafter, referred to as the quench start section), demagnetization is safely achieved as follows. First, a normal conducting region immediately propagates in the coil LM or LC where the quench has occurred, and thus the resistance of the coil LM or LC increases and the current of the quench start section S decreases. Then, in the different section S other than the quench start section S, the current increases due to electromagnetic induction based on magnetic coupling between the coil LM or LC in the quench start section S and the different section S. As a result, the current flowing through the coil LM or LC in the different section exceeds a critical current to cause the coil LM or LC to quench. After that, similarly, a chain reaction where the coil in the further different section S quenches occurs, and the quench propagates across the sections S from the coil LM or LC to the coil LM or LC. As mentioned above, the quenching of the coil LM or LC in such a process occurs when the flowing current in the coil increases due to the electromagnetic induction and exceeds the critical current. At this time, the decrease in the critical current due to the temperature increase caused by an AC loss (coupling loss or magnetization loss) caused by the change in an external magnetic field that the coil experiences also contributes to the occurrence and propagation of the quench. As a result, the magnetic energy stored by a large number of the superconducting coils is converted into the Joule heat in a large number of the coils LM and LC over a wide range, and thus, demagnetization is safely achieved while avoiding the localized and excessive temperature increase.

Further, in Non-Patent Literature 1, the main coil HM made of the high-temperature superconductor and the main coil LM made of the low-temperature superconductor are provided in the same section S. As a result, when the main coil LM quenches in the section S, the resistance occurs in the main coil LM and the current flowing in the main coil LM decreases. Along with this, the current of the main coil HM in the same section S also decreases. As a result, the current increase in the main coil HM is suppressed to prevent the main coil HM made of the high-temperature superconductor from quenching.

However, as a result of the electro-thermal coupled analysis on the configuration illustrated in FIG. 1, the inventors of the present application have found that the suppression of the current increase in the main coil HM made of the high-temperature superconductor cannot be sufficiently achieved. In other words, in the process where the quench occurs in the coil LM or LC in any one of the sections S and the quench propagates as described above, when the specific coil LM (e.g., the coil LM having high critical temperature among the low-temperature superconductor coils) quenches, the current of the main coil LM in the same section as that of the main coil HM made of the high-temperature superconductor excessively increases due to the electromagnetic induction based on magnetic coupling with the specific coil LM, and thus the current flowing through the main coil HM made of the high-temperature superconductor may exceed the critical current.

In view of the above, an object of the present invention is to provide a new technique enabling suppression of a current increase in a high-temperature superconductor (HTS) main coil when a quench occurs in a low-temperature superconductor (LTS) section, in a superconducting magnet device that includes the HTS main coil and at least one (LTS) main coil and has a configuration in which an HTS section including the HTS main coil and an LTS coil connected in series with each other is connected in series with an LTS section including the LTS main coil.

A superconducting magnet device according to a first aspect of the present invention includes a plurality of sections that are connected in series with each other. The plurality of sections each includes a coil portion and a shunt circuit that are connected in parallel with each other. The coil portion includes a superconducting coil. The plurality of sections includes: one or more low-temperature superconductor (LTS) sections that each include an LTS main coil as the superconducting coil in the coil portion; and a high-temperature superconductor (HTS) section that includes, as the superconducting coil in the coil portion, an HTS main coil and a combination coil connected in series with each other. The combination coil is an LTS sub-coil that generates a magnetic field for correcting a magnetic field generated by at least one of the HTS main coil and the LTS main coil. A specific LTS main coil that is the LTS main coil is arranged between the HTS main coil on an inner side and the combination coil on an outer side in a radial direction with respect to a central axis of the superconducting magnet device.

According to the present invention, in the superconducting magnet device that includes the HTS main coil and at least one LTS main coil, a current increase in the HTS main coil can be suppressed when a quench occurs in the LTS section, in a configuration in which the HTS section including the HTS main coil and the LTS coil connected in series with each other is connected in series with the LTS section including the LTS main coil.

### BRIEF DESCRIPTION OF THE DRAWINGS

FIG. 1 is a circuit diagram illustrating a superconducting magnet device disclosed in Non-Patent Literature 1;
FIG. 2 is an explanatory diagram illustrating a radial-direction distance between coils;
FIG. 3 is an example of a circuit diagram illustrating a superconducting magnet device according to a first embodiment of the present invention;
FIG. 4 illustrates a three-dimensional positional relation of a plurality of superconducting coils in FIG. 2;
FIG. 5A is a graph illustrating a voltage to ground in an HTS section;
FIG. 5B is another graph illustrating a voltage to ground in the HTS section;
FIG. 6 is an example of a circuit diagram illustrating the superconducting magnet device according to a second embodiment of the present invention;
FIG. 7 is another example of a circuit diagram illustrating the superconducting magnet device according to the second embodiment of the present invention;
FIGS. 8A to 8C illustrate simulation results when quench occurs in the conventional configuration illustrated in FIG. 1;
FIGS. 9A to 9C illustrate simulation results when quench occurs in the configuration example according to the second embodiment illustrated in FIG. 7;
FIGS. 10A and 10B illustrate experimental results when quench occurs in the configuration example according to the second embodiment illustrated in FIG. 7;
FIGS. 11A to 11C illustrate other simulation results when quench occurs in the configuration example according to the second embodiment illustrated in FIG. 7;
FIG. 12 is an example of a circuit diagram illustrating the superconducting magnet device according to a third embodiment of the present invention;
FIG. 13 illustrates a three-dimensional positional relation of a plurality of superconducting coils in FIG. 12;
FIGS. 14A and 14B illustrate simulation results when quench occurs in the configuration example according to the third embodiment illustrated in FIG. 12; and
FIG. 15 illustrates the superconducting magnet device according to a fourth embodiment of the present invention.

### DESCRIPTION OF THE EMBODIMENTS

### (First Aspect)

A superconducting magnet device according to the first aspect of the present invention includes a plurality of sections connected in series with each other. Each of these sections has a configuration in which a coil portion including a superconducting coil is connected in parallel with a shunt circuit. The plurality of sections include one or more LTS sections and one or more HTS sections. Each of the LTS sections includes, in the coil portion, an LTS main coil that is a superconducting coil. Each of the HTS sections includes, as the coil portion, an HTS main coil and a combination coil that are superconducting coils and are connected in series with each other. The combination coil is an LTS sub-coil that generates a magnetic field for correcting a magnetic field generated by one or both of the HTS main coil and the LTS main coil (e.g., for improving the uniformity of the magnetic field or for reducing the leakage of the magnetic field to the outside). A specific LTS main coil included in the LTS main coils is arranged between the HTS main coil on an inner side and the combination coil on an outer side in a radial direction (hereinafter, simply called radial direction) relative to a central axis of the superconducting magnet device (hereinafter, such the specific LTS main coil is simply referred to as a specific LTS main coil).

In the first aspect, a plurality of the LTS main coils constituting the superconducting magnet device may be provided. In this case, the following first or second configuration example may be employed.

In the first configuration example, the plurality of LTS main coils include one or more LTS main coils made of a first superconductor and one or more LTS main coils made of a second superconductor different from the first superconductor. For example, the first superconductor may be Nb₃Sn and the second superconductor may be NbTi, but the present invention is not limited to this example.

In the second configuration example, the plurality of LTS main coils are made of the same specific superconductor (i.e., have the same critical temperature). In the second configuration example, for example, the superconducting magnet device may be configured so as not to include LTS coils (i.e., LTS main coil and LTS sub-coil) made of a superconductor different from the above-described same specific superconductor in addition to the plurality of LTS main coils made of the above-described same specific superconductor. In the second configuration example, the specific LTS main coil may indicate an arbitrary one of the plurality of LTS main coils, or may indicate each (all) of the plurality of LTS main coils. The above-described same specific superconductor in the second configuration example may be NbTi for example, but the present invention is not limited to this example.

In the first aspect (e.g., in the first or second configuration example), the one or more HTS main coils constituting the superconducting magnet device may be made of REBCO described below for example, or may be made of any of other materials.

### (Second to Fourth Aspects)

According to the second aspect, in the first aspect, the specific LTS main coil is adjacent to the HTS main coil from the outside of the HTS main coil in the radial direction. According to the third aspect, in the first or second aspect, a different LTS main coil is provided as the LTS main coil in addition to the specific LTS main coil, and the specific LTS main coil has a critical temperature higher than that of the different LTS main coil.

According to the fourth aspect, in any one of the first to third aspects, the specific LTS main coil is made of Nb₃Sn that is the low-temperature superconductor (the first superconductor).

### (More Detailed Description and Effects of Aspects)

The above-described first, second, third, or fourth aspect may have any some or all of the following configurations and effects.

The specific LTS main coil may be made of a low-temperature superconductor having relatively high critical temperature among the low-temperature superconductors. The specific LTS main coil may be a superconducting coil having the highest critical temperature among all the superconducting coils made of the low-temperature superconductors in the superconducting magnet device. Such the specific LTS main coil may be made of, for example, Nb₃Sn that is the low-temperature superconductor.

In this premise configuration, when the specific LTS main coil quenches, at the time of this quenching, a current value of the specific LTS main coil tends to be high due to electromagnetic induction. In the situation, the high current value of the specific LTS main coil greatly decreases due to occurrence of electric resistance, and a current value of the combination coil greatly increases due to the electromagnetic induction caused by magnetic coupling between the specific LTS main coil and the combination coil in the HTS section. As a result, the current of the HTS main coil may exceed the critical current and thus the HTS main coil may quench.

For example, since the specific LTS main coil has relatively high critical temperature, when the quench begins from the different LTS coil (e.g., the different LTS main coil or the below-described LTS sub-coil) having relatively low critical temperature lower than that of the specific LTS main coil, the quench of the specific LTS main coil is delayed to the extent that the critical temperature is high. For this reason, before the specific LTS main coil quenches, the current value of the specific LTS main coil easily becomes high due to the electromagnetic induction based on the current decrease of the different LTS coil. As a result, when the specific LTS main coil quenches in a state where the current value of the specific LTS main coil is high, the high current value greatly decreases sharply. Due to the electromagnetic induction based on the sharp decrease of the high current value, the current of the combination coil in the HTS section increases greatly and the current of the HTS main coil also increases greatly to exceed the critical current, and thus the HTS main coil may quench.

In contrast to this, the specific LTS main coil is arranged between the HTS main coil on an inner side in the radial direction and the combination coil that is the LTS sub-coil on an outer side in the radial direction. As described above, the LTS sub-coil as the combination coil arranged on the outer side has the number of coil turns smaller than that of the LTS main coil (e.g., the LTS sub-coil as each of the combination coils constituting the superconducting magnet device has the number of coil turns smaller than that of each of the LTS main coils constituting the superconducting magnet device). Thus, the combination coil has relatively small magnetic coupling (mutual inductance) with the specific LTS main coil. Accordingly, this relatively small magnetic coupling suppresses the great increase in the current value of the combination coil caused by the electromagnetic induction based on the above-described great current decrease in the specific LTS main coil when the specific LTS main coil quenches. For this reason, the current increase in the HTS section, i.e., the current increase in the HTS main coil can be suppressed.

In an example, among the plurality of LTS sub-coils constituting the superconducting magnet device, each of one or more (e.g., all) LTS sub-coils as the combination coils has the number of coil turns smaller than that of each of one or more (e.g., all) LTS sub-coils that are not the combination coils. Thus, magnetic coupling (mutual inductance) between the combination coil and the specific LTS main coil (and the different LTS main coil) can become further reduced.

Further, a radial-direction distance between the combination coil and the specific LTS main coil may be larger than a radial-direction distance between the superconducting coils adjacent to each other in the radial direction. This arrangement can also reduce, accordingly, the magnetic coupling (mutual inductance) between the combination coil and the specific LTS main coil to be relatively small.

Here, the radial-direction distance between the superconducting coils means a distance between the superconducting coils in the radial direction. The combination coil and the specific LTS main coil may overlap at least partially with each other in the radial direction, or may be arranged so as not to overlap with each other in the radial direction. Meanwhile, the superconducting coils adjacent to each other in the radial direction overlap at least partially with each other in the radial direction.

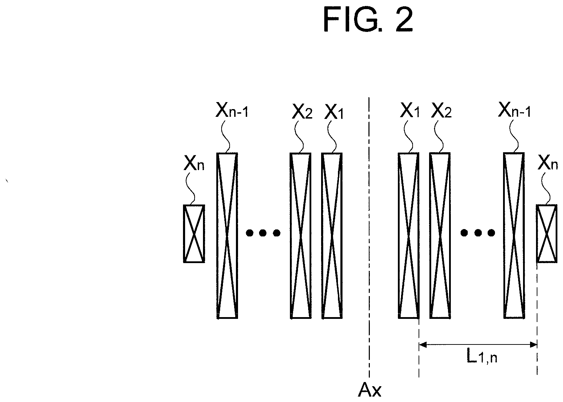

More specifically, a radial-direction distance between arbitrary two superconducting coils means a radial-direction distance between an outer peripheral surface of the one superconducting coil located on a radial-direction inner side and an inner peripheral surface of the other superconducting coil located on a radial-direction outer side. FIG. 2 illustrates as an example a case where n superconducting coils X₁, X₂, ... Xₙ₋₁, and Xₙ constituting the superconducting magnet device have a common central axis Ax. In FIG. 2, for example, a radial-direction distance L₁, ₙ between the superconducting coil X₁ and the superconducting coil Xₙ is a radial-direction distance between the outer peripheral surface of the superconducting coil X₁ and the inner peripheral surface of the superconducting coil Xₙ. The radial-direction distance is also described in the below-described embodiments.

The plurality of LTS main coils constituting the superconducting magnet device may include a first LTS main coil that is the specific LTS main coil made of the first superconductor and a second LTS main coil made of the second superconductor. Here, the critical temperature of the first superconductor is higher than the critical temperature of the second superconductor by 3 K or more, 5 K or more, or 7 K or more. As an example, the first superconductor is Nb₃Sn and the second superconductor is NbTi, but the combination of the first superconductor and the second superconductor is not limited to this example.

The HTS main coils and the LTS main coils generate a main magnetic field in a predetermined area. The LTS sub-coil may be a correction coil that generates a magnetic field for increasing the uniformity of the main magnetic field in the predetermined area. Alternatively, the LTS sub-coil may be a shield coil that generates a magnetic field for suppressing the leakage of the magnetic field to the outside of the predetermined area. Alternatively, both of the correction coil and the shield coil may be provided as the LTS sub-coils (e.g., the combination coils).

The mutual inductance between the combination coil (the LTS sub-coil) in the HTS section and the LTS main coil (e.g., each of the LTS main coils including the specific LTS main coil) may be a negative value. As a result, when this LTS main coil quenches, the current increase in the HTS coil can be further suppressed as follows When this LTS main coil quenches, the resistance of this LTS main coil occurs and thus the current flowing in this LTS coil decreases. The electromagnetic induction based on this current decrease affect the current of the combination coil in the HTS section so as to be decreased because of the mutual inductance having the negative value. As a result, the current increase in the HTS coil can be further suppressed.

Hereinafter, exemplary embodiments of the present invention are described with reference to the accompanying drawings. The same reference sign is allocated to the corresponding part in each of the drawings, and duplicate description is omitted.

### [First embodiment]

A superconducting magnet device according to the first embodiment is a device that generates a magnetic field by a current flowing through a plurality of superconducting coils. The superconducting magnet device is used in, for example, NMR, MRI, a magnet for physical experiments, an accelerator, a linear railway, a nuclear fusion reactor, a motor, an electric generator, a silicon single-crystal pulling apparatus, an aluminum melting apparatus, or the like.

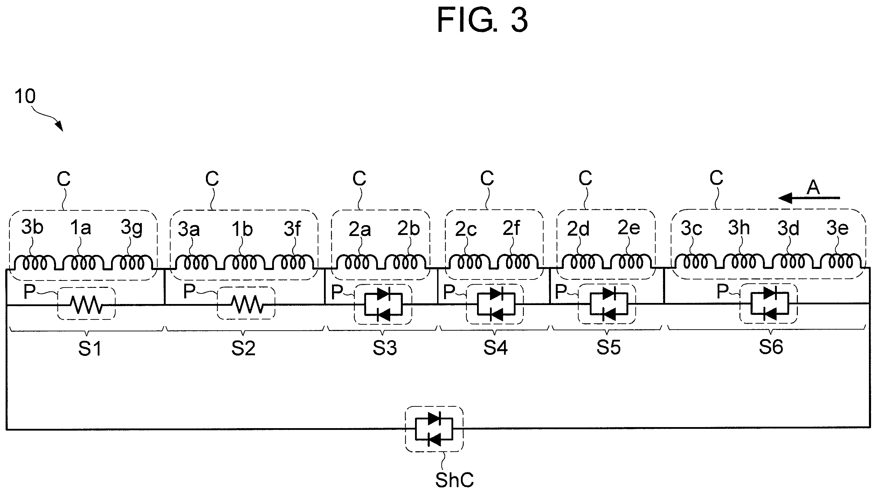

FIG. 3 is a circuit diagram illustrating the superconducting magnet device 10 according to the first embodiment of the present invention. A plurality of superconducting coils 1a, 1b, 2a to 2f, 3a to 3h constituting the superconducting magnet device 10 are connected in series with each other as in FIG. 3 in the present embodiment. Here, the superconducting coils 1a and 1b are the HTS main coil, the superconducting coils 2a to 2f are the LTS main coil, and the superconducting coils 3a to 3h are the LTS sub-coil.

### <Section>

The superconducting magnet device 10 includes a plurality of sections S1 to S6 that are connected in series with each other. Each of the sections S1 to S6 includes a coil portion C that includes superconducting coils and a shunt circuit P that is connected in parallel with the coil portion C. In the first embodiment, it is assumed that a current flows through the coils in the plurality of sections S1 to S6 in the constant direction (the direction of the arrow A in FIG. 3) in a state where the superconducting magnet device 10 normally generates a magnetic field.

The superconducting magnet device 10 may include a short circuit ShC. The short circuit ShC is connected to both ends of a circuit in which the plurality of sections (the sections S1 to S6 in FIG. 3) constituting the superconducting magnet device 10 are connected in series with each other. In other words, the both ends are connected via the short circuit ShC. In FIG. 1, the short circuit ShC is a bidirectional diode circuit. The bidirectional diode circuit ShC may be configured to include a forward diode and a reverse diode that are connected in parallel with each other. Although not illustrated, a persistent current switch may be connected in parallel with the short circuit ShC. The persistent current switch may be configured to include a superconducting wire and a heater.
The persistent current switch may be set to an OFF state by heat input caused by turning on the heater, and may be set to an ON state when the heat input is removed by turning off the heater. During steady-state operation, a current flows so as to circulate through a plurality of sections constituting the superconducting magnet device 10 and the persistent current switch (i.e., the superconducting wire) in the ON state. Thereby, the superconducting magnet device 10 is operated in a persistent current mode. Similarly, also in the superconducting magnet device 10 according to the below-described second to fourth embodiments, the persistent current switch may be connected in parallel with the short circuit ShC.

In this regard, however, the superconducting magnet device 10 may be operated in a state of being connected to an external DC power supply without including the persistent current switch. In the present specification, a configuration concerning any of the embodiments, the corresponding drawings (including FIG. 1), and the examples may be made so as to include or exclude the persistent current switch.

The plurality of sections S1 to S6 include the HTS sections S1 and S2 and the LTS sections S3 to S6. The HTS sections S1 and S2 include the HTS main coils 1a and 1b, respectively, in the coil portion C. The LTS sections S3 to S6 include the LTS main coils 2a to 2f or the LTS sub-coils 3a to 3h in the coil portion C. In the first embodiment, the coil portions C of the HTS sections (the HTS sections S1 and S2 in FIG. 3) do not include any of the LTS main coils (the LTS main coils 2a to 2f in FIG. 3).

As illustrated in FIG. 3, the coil portion C in each of the sections S1 to S6 may include a plurality of the superconducting coils connected in series with each other. In this case, the coil portion C in each of the sections S1 to S6 may include two, three, or more superconducting coils selected from among the HTS main coils 1a and 1b, the LTS main coils 2a to 2f, and the LTS sub-coils 3a to 3h. In this regard, however, according to the present invention, the coil portion in one LTS section may include only one LTS main coil or LTS sub-coil.

As illustrated in FIG. 3, the plurality of HTS sections S1 and S2 may be provided. According to the first embodiment, each of the HTS sections S1 and S2 includes, in the coil portion C, the HTS main coil 1a or 1b and the two LTS sub-coils 3b and 3g or 3a and 3f. Here, in each of the HTS sections S1 and S2, the series connection of the HTS main coil 1a or 1b and the two LTS sub-coils 3b and 3g or 3a and 3f is formed such that the HTS main coil 1a or 1b is sandwiched between the two LTS sub-coils 3b and 3g or 3a and 3f. In other words, in the coil portion C of each of the HTS sections S1 and S2, the LTS sub-coil 3b or 3a, the HTS main coil 1a or 1b, and the LTS main coil 3g or 3f are connected in series with each other in order of the LTS sub-coil 3b or 3a, the HTS main coil 1a or 1b, and the LTS main coil 3g or 3f. In the first embodiment, the number of HTS sections may be two or more, or may be one.

Each of the LTS sections S3 to S6 is a section that does not include any of HTS coils such as the HTS main coils and includes the LTS coil such as the LTS main coil and the LTS sub-coil in the coil portion C. As illustrated in FIG. 3, the plurality of LTS sections S3 to S6 may be provided. As illustrated in FIG. 3, each of the LTS sections S3 to S5 may include the plurality of LTS main coils 2a and 2b, 2c and 2f, or 2d and 2e in the coil portion C, and the other LTS section S6 may include the plurality of LTS sub-coils 3c, 3h, 3d, and 3e in the coil portion C. In the first embodiment, the number of the LTS sections may be one.

### <Main Coils and Sub-Coils>

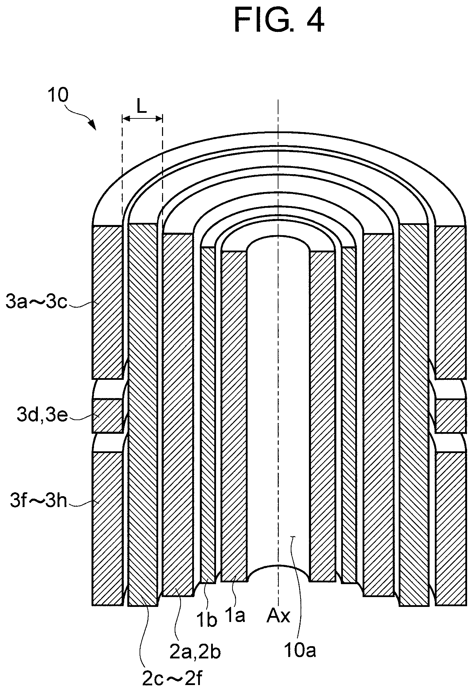

Each of the HTS main coils 1a and 1b and the LTS main coils 2a to 2f constituting the superconducting magnet device 10 generates, in a predetermined area (in this embodiment, the below-described internal space 10a), a main magnetic field for intended use of the superconducting magnet device 10. Meanwhile, the LTS sub-coils 3a to 3h generate a magnetic field for correcting the magnetic field generated by the HTS main coils 1a and 1b and the LTS main coils 2a to 2f. As illustrated in FIG. 4, the LTS sub-coils 3a to 3h may be correction coils that generate a magnetic field for increasing the uniformity of the magnetic field in the predetermined area. For example, when each of the HTS main coils 1a and 1b and the LTS main coils 2a to 2f has a cylindrical shape, a component that constitutes the main magnetic field generated by each of the HTS main coils 1a and 1b and the LTS main coils 2a to 2f and that is proportional to the square of a coordinate on a z-axis coinciding with the below-described central axis Ax (see Fig. 4) is negative. Accordingly, in this case, the correction coils 3a to 3h are designed so that the corresponding component has a positive value (e.g., see Japanese Laid-Open Patent Application 2014-240797). In this regard, however, the LTS sub-coils 3a to 3h are not limited to the correction coils, and as in the below-described first modification example, the LTS sub-coils may be shield coils that generate a magnetic field for suppressing the leakage of the magnetic field to the outside of the predetermined area.

In this embodiment, the magnitude of the main magnetic field in the axial direction (i.e., a direction parallel to the central axis Ax) generated, in the predetermined area (e.g., the internal space 10a), by each of the HTS main coils 1a and 1b and the LTS main coils 2a to 2f (i.e., each coil) may be larger than the magnitude of the magnetic field in the axial direction generated by each of the LTS sub-coils 3a to 3h.

### <Shunt Circuit>

In the example of FIG. 3, the shunt circuit P in each of the HTS sections S1 and S2 is an electric resistance, and the shunt circuit P in each of the LTS sections S3 to S6 is a bidirectional diode. The bidirectional diode may be configured to include a forward diode and a reverse diode connected in parallel with each other. In this regard, however, the shunt circuits P in the HTS sections and the LTS sections are not limited to the example illustrated in FIG. 3, and may each have a different configuration (e.g., a configuration as a resistor and a forward diode connected in series with each other, or a configuration as a thyristor).

### <Three-Dimensional Positional Relation Between Coils>

FIG. 4 illustrates an example of a three-dimensional positional relation between the plurality of superconducting coils (the plurality of superconducting coils 1a, 1b, 2a to 2f, and 3a to 3h illustrated in FIG. 3) that constitute the superconducting magnet device 10. In other words, FIG. 4 is a schematic perspective view illustrating an example of a cross section of the superconducting magnet device 10. This cross section is a cross section taken along a virtual plane including the central axis Ax of the superconducting magnet device 10. A cross section of the superconducting magnet device 10 taken along any virtual plane including the central axis Ax may be the same cross section as that of FIG. 4. Hereinafter, a direction parallel to the central axis Ax is simply referred to as an axial direction, and a radial direction (direction perpendicular to the axial direction) to the central axis Ax is simply referred to as a radial direction. The superconducting magnet device 10 illustrated in FIG. 4 may be used in NMR, for example.

As illustrated in FIG. 4, the plurality of superconducting coils 1a, 1b, 2a to 2f, and 3a to 3h constituting the superconducting magnet device 10 are arranged coaxially with each other. In other words, the plurality of superconducting coils 1a, 1b, 2a to 2f, and 3a to 3h constituting the superconducting magnet device 10 has the common central axis Ax. Thus, the plurality of superconducting coils have the common internal space 10a. The central axis of the internal space 10a may coincide with the above-described central axis Ax.

As illustrated in FIG. 4, the plurality of superconducting coils 1a, 1b, 2a to 2f, and 3a to 3h constituting the superconducting magnet device 10 are arranged from a radial-direction inner side to a radial-direction outer side in order of the HTS main coil 1a, the HTS main coil 1b, the LTS main coil 2a, the LTS main coil 2b, the LTS main coil 2c, the LTS main coil 2d, the LTS main coil 2e, the LTS main coil 2f, while on a radial-direction outer side of the LTS main coil 2f, a set of the LTS sub-coils 3a to 3c, a set of the LTS sub-coils 3d and 3e, and a set of the LTS sub-coils 3f to 3h are provided such that these sets are arranged in this order in the axial direction. The LTS sub-coils 3a to 3c are arranged in this order from a radial-direction inner side to a radial-direction outer side. Similarly, the LTS sub-coils 3d and 3e are arranged in this order from a radial-direction inner side to a radial-direction outer side, and the LTS sub-coils 3f to 3h are arranged in this order from a radial-direction inner side to a radial-direction outer side.

### <Superconducting Materials of Coils>

The high-temperature superconductor that forms each the HTS main coil may be Bi₂Sr₂Ca₂Cu₃Oₓ (Bi2223) or REBa₂Cu₃Oₓ (REBCO). Here, RE is a rare earth element. The LTS main coils 2a and 2b are each an example of the specific LTS main coil (the first LTS main coil) having relatively high critical temperature among the low-temperature superconductors. The low-temperature superconductor that forms the LTS main coils 2a and 2b may be Nb₃Sn. The low-temperature superconductor that forms the different LTS main coils 2c to 2f (an example of the second LTS main coil) and each of the LTS sub-coils 3a to 3h may be NbTi. In this regard, however, these superconductors are merely examples, and the HTS main coils 1a and 1b, the LTS main coils 2a to 2f, and the LTS sub-coils 3a to 3h may be made of superconductors other than the above.

In the example of the first embodiment, in FIG. 3, as described above, the LTS main coils 2a and 2b in the LTS section S3 are made of Nb₃Sn as the superconductor. In this case, in FIG. 3, the LTS main coils 2c to 2f are made of NbTi as the superconductor.

Since Nb₃Sn has the high critical temperature compared to NbTi, for example, Nb₃Sn has a large temperature margin (difference between the operating temperature of the superconducting magnet device 10 and the temperature at which the quench occurs). For that reason, for example, when the quench begins from any one of the LTS main coils 2c to 2f made of the different superconductor (e.g., NbTi), the LTS main coils 2a and 2b made of Nb₃Sn results in the delayed quench as the critical temperature is high. Thus, before the LTS main coil 2a or 2b quenches, a current value of the LTS main coil 2a or 2b tends to especially become high due to the electromagnetic induction based on the current decrease in the LTS main coils made of the different superconductors. As a result, when the LTS main coil 2a or 2b quenches in a state where the current value (i.e., current density: current value per unit cross-sectional area) of the LTS main coil 2a or 2b made of Nb₃Sn is high, the high current value sharply decreases greatly due to the occurrence of the electric resistance. The electromagnetic induction based on the sharp decrease in the high current value may cause the current of the combination coils 3b, 3g, 3a, and 3f in the HTS sections S1 and S2 to increase greatly, and thus, the current of the HTS main coil 1a or 1b may also increase greatly.

In order to avoid this, the radial-direction distance between the combination coil and each of the LTS main coils 2a and 2b (an example of the specific LTS main coil) made of Nb₃Sn is larger than the radial-direction distance between the superconducting coils adjacent to each other in the radial direction. The radial-direction distance between the superconducting coils is a radial-direction distance between the outer peripheral surface of the one coil located on a radial-direction inner side and the inner peripheral surface of the other coil located on a radial-direction outer side. For example, a radial-direction distance L between the specific coil 2b and the combination coil 3a is the radial-direction distance L between the outer peripheral surface of the specific coil 2b and the inner peripheral surface of the combination coil 3a as illustrated in FIG. 4. The above-described radial-direction distance between the superconducting coils adjacent to each other in the radial direction may be a constant value when this distance is constant irrespective of pairs of the main coils adjacent to each other in the radial direction as in the case of Fig. 4, and may be a minimum value among different values of this distance when this distance varies depending on pairs of main coils adjacent to each other in the radial direction. The relation described here may be established for the combination coils (the combination coils 3b, 3g, 3a, and 3f in FIG. 3). In other words, for each of the combination coils, a radial-direction distance between the combination coil and each of the LTS main coils 2a and 2b made of Nb₃Sn is larger than the radial-direction distance between the superconducting coils adjacent to each other in the radial direction.

Such a relation may be established by setting the relative three-dimensional position between the plurality of superconducting coils constituting the superconducting magnet device 10. For each of the combination coils, the radial-direction distance between the corresponding combination coil and each of the LTS main coils 2a and 2b may be larger than the radial-direction distance between the combination coil and any of the LTS main coils 2c to 2f.

### <Polarity of each coil>

Each of the HTS main coils 1a and 1b and the LTS main coils 2a to 2f constituting the superconducting magnet device 10 may generate, in the predetermined area, the magnetic field in the same positive axial direction (i.e., a direction parallel to the central axis Ax) that is one of the two positive and negative axial directions opposite to each other.

In this case, among the plurality of LTS sub-coils 3a to 3h, the LTS sub-coils 3a to 3c and 3f to 3h may generate a magnetic field in the positive axial direction in the predetermined area, and the remaining LTS sub-coils 3d and 3e may generate a magnetic field in the negative axial direction in the predetermined area.

Among the two positive and negative axial directions opposite to each other, a polarity of the superconducting coil that generates a magnetic field in the positive axial direction in the predetermined area (in the example of FIG. 3, the internal space 10a) is defined as positive, and a polarity of the superconducting coil that generates a magnetic field in the negative axial direction in the predetermined area is defined as negative. In the example of FIGS. 3 and 4, the polarities of the HTS main coils 1a and 1b, the LTS main coils 2a to 2f, and the LTS sub-coils 3a to 3c, 3f, and 3g are positive, and the polarities of the LTS sub-coils 3d and 3e are negative. In other words, in the example of FIGS. 3 and 4, only the polarities of the LTS sub-coils 3d and 3e are negative, and the polarities of the other superconducting coils are positive.

### <Relation of Magnetic Coupling>

According to the first embodiment, the radial-direction distance between each of the combination coils 3b, 3g, 3a, and 3f and each of the specific LTS main coils 2a and 2b made of Nb₃Sn is larger than the radial-direction distance between the superconducting coils adjacent to each other in the radial direction. As described above, each of the combination coils are separated from each of the specific LTS main coils 2a and 2b by a distance larger than the radial-direction distance between the superconducting coils adjacent to each other in the radial direction. As a result, the absolute value of the mutual inductance (magnetic coupling) between each the combination coils and each of the specific LTS main coils 2a and 2b is suppressed to be small.

The mutual inductance between each pair of the LTS main coils having the positive polarities has a positive value. In other words, for each pair of these LTS main coils, when a current generating a magnetic field in the positive axial direction decreases in one of the LTS main coils, a current generating a magnetic field in the positive axial direction increases in the other of the LTS main coils due to the electromagnetic induction based on the decrease in the current.

As illustrated in FIG. 3, each of the combination coil 3b, 3g, 3a, and 3f may have the positive polarity. In this case, the mutual inductance between each of the combination coil 3b, 3g, 3a, and 3f and any of the LTS main coils constituting the superconducting magnet device 10 has a positive value.

Alternatively, in the first embodiment, the mutual inductance between each of the combination coils in the HTS section and each of the LTS main coils may have a negative value. In this case, the mutual inductance between each of the combination coils in the HTS section and any of the LTS main coils has a negative value.

In FIG. 3, in an example, when the LTS sub-coil 3b or 3g has the positive polarity and the LTS sub-coil 3d or 3e has the negative polarity, the LTS sub-coil 3b or 3g and the LTS sub-coil 3d or 3e may be replaced with each other such that the coil portion of the HTS section S1 includes the LTS sub-coil 3d or 3e having the negative polarity as the combination coil, and this combination coil has the negative mutual inductance with any of the LTS main coils. In this case, in addition to this or instead of this, in FIG. 3, when the LTS sub-coil 3a or 3f has the positive polarity and the LTS sub-coil 3e or 3d has the negative polarity, the LTS sub-coil 3a or 3f and he LTS sub-coil 3e may be replaced with each other such that the coil portion of the HTS section S2 includes the LTS sub-coil 3e or 3d having the negative polarity as the combination coil, and this combination coil has the negative mutual inductance with any of the LTS main coils. In this case, the coil portion(s) C of one or both of the HTS sections S1 and S2 may be configured so as not to include a combination coil having the positive polarity. In other words, when one or more sub-coils having the positive polarity are included in the sub-coils 3b, 3g, 3a, and 3f, such one or more sub-coils may be arranged in any one of the LTS sections S3 to S6.

As described above, in the case where the mutual inductance between the combination coil in the HTS section and the LTS main coil has a negative value, when a current generating a magnetic field in the positive axial direction decreases in this LTS main coil due to the resistance generated by the quench, the electromagnetic induction based on the current decrease in this LTS main coil causes a decrease in a current of this combination coil generating a magnetic field in the positive axial direction.

### (Advantageous Effects of First Embodiment)

According to the superconducting magnet device 10 of the first embodiment, the following advantageous effects (1) to (4) can be achieved.
(1) For each of the combination coils in the HTS section, the radial-direction distance between the combination coil and the specific LTS main coil (e.g., the LTS main coil with the critical temperature larger than NbTi) in the LTS section is larger than the radial-direction distance between the superconducting coils adjacent to each other in the radial direction. This arrangement can suppress an increase in a current in the combination coil that is caused by the electromagnetic induction based on the above-described large current decrease in the specific LTS main coil when the specific LTS main coil in the LTS section quenches. Thus, a current increase in the HTS section, i.e., a current increase in the HTS main coil can be suppressed.

Such a combination coil may be the above-described LTS sub-coil.

For example, as illustrated in FIG. 4, the combination coil connected in series with the HTS main coil in the HTS section is arranged at a position different from each of the LTS main coils in the radial direction, is arranged on a radial-direction outer side of each of the LTS main coils, and is separated from the specific LTS main coil via the different LTS main coil in the radial direction. As a result, the radial-direction distance between the combination coil and the specific LTS main coil can be increased to reduce the mutual inductance between the combination coil and the specific LTS main coil. Thus, when the specific LTS main coil quenches, this arrangement can suppress an increase in a current of the combination coil in the HTS section caused by the influence of this quench as described above.

(2) In each of the coil portions C of the HTS sections S1 and S2, the combination coil, the HTS main coil, and the combination coil are connected in series to each other in this order. With this configuration, when each of the combination coils quenches in the HTS section, an increase in a voltage to ground at a boundary portion between the HTS main coil and each of the combination coils can be suppressed.

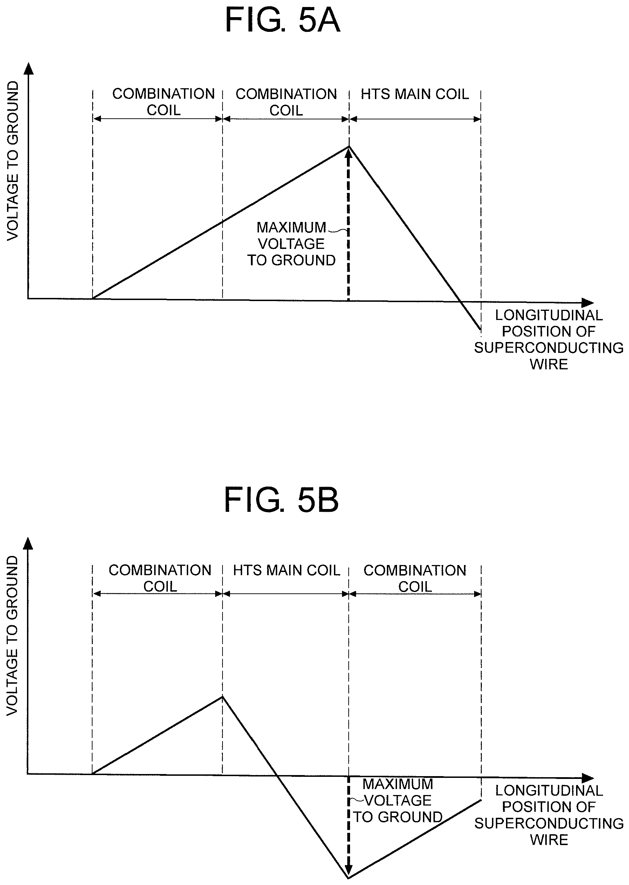

FIGS. 5A and 5B illustrate a voltage to ground in relation to a longitudinal position of the superconducting wire in each of the two combination coils and the HTS main coil when each of the combination coils (LTS sub-coils) quenches and the HTS main coil does not quench in the HTS section. FIG. 5A illustrates the case where the two combination coils and the HTS main coil in the HTS section are connected in series to each other in this order. FIG. 5B illustrates the case where the combination coil, the HTS main coil, and the combination coil in the HTS section are connected in series to each other in this order.

As illustrated in FIGS. 5A and 5B, an absolute value of the maximum voltage to ground can be suppressed by sandwiching the HTS main coil between the two combination coils in the series connection as in FIG. 5B. As a result, the dielectric breakdown and the arc discharge can be prevented. In this regard, when the arc discharge occurs due to the increase in the voltage to ground, for example, the superconducting coil may be damaged to an irreparable extent.

(3) The mutual inductance between the combination coil and the LTS main coil (e.g., each of the LTS main coils including the specific LTS main coil) may have a negative value. With this configuration, when the LTS main coil quenches, the resistance of this LTS main coil occurs to decrease the current flowing in this LTS coil. The electromagnetic induction based on the current decrease causes a decrease in a current of the combination coil due to the mutual inductance having a negative value. As a result, an increase in a current of the HTS coil in the HTS section including this combination coil can be further suppressed.

(4) An increase in hoop stress acting on the HTS main coil can be suppressed as follows. When a current of the HTS main coil excessively increases, a radial-direction force (hoop stress) applied to the HTS main coil by the magnetic field also increases excessively, and thus may cause the mechanical damage to the HTS main coil and the like. In contrast to this, the current increase in the HTS main coil can be suppressed by at least one of the above-described advantageous effects (1) and (3), and thus, the excessive increase in the hoop stress of the HTS main coil can be suppressed. For this reason, the HTS main coil and the like can be prevented from being mechanically damaged due to the excessive increase in the hoop stress.

### [Second Embodiment]

Hereinafter, the superconducting magnet device 10 according to the second embodiment of the present invention is described. In the second embodiment, the matters that are not described below may be the same as those in the first embodiment.

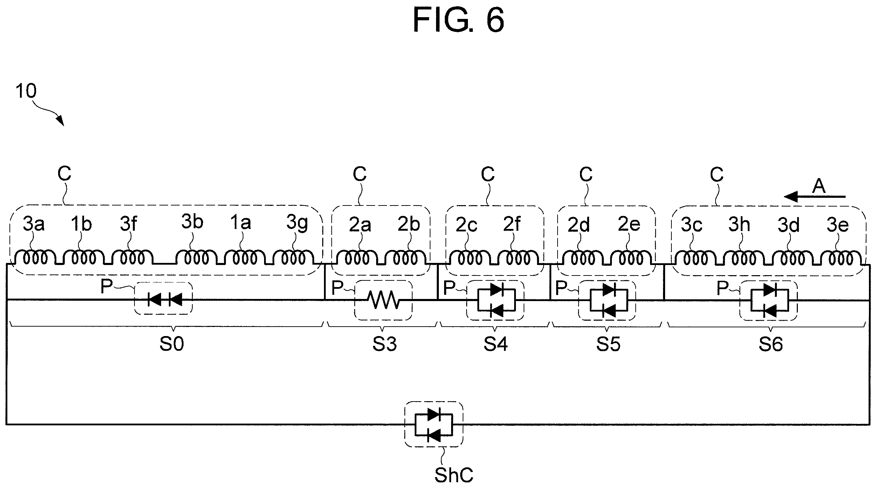

FIG. 6 is a circuit diagram illustrating the superconducting magnet device 10 according to the second embodiment of the present invention. The three-dimensional positional relation of the plurality of superconducting coils 1a, 1b, 2a to 2f, and 3a to 3h constituting the superconducting magnet device 10 according to the second embodiment is the same as the positional relation described in the first embodiment with reference to FIG. 4.

In the second embodiment, the two HTS main coils are included in the coil portion C of the one HTS section. In an example of FIG. 6, the above-described sections S1 and S2 in FIG. 3 are integrated into one HTS section (hereinafter, referred to as an HTS section S0). In other words, as illustrated in FIG. 6, the HTS sections S1 and S2 in FIG. 3 are integrated into the one HTS section S0 while the HTS section S1 and the HTS section S2 in FIG. 3 are replaced with each other in terms of the order in the series connection.

In the example of FIG. 6, in the coil portion C of the HTS section S0, the LTS sub-coil 3a, the HTS main coil 1b, the LTS sub-coil 3f, the LTS sub-coil 3b, the HTS main coil 1a, and the LTS sub-coil 3g are arranged in this order from the downstream side to the upstream side of the current and are connected to each other in series.

In the second embodiment, the shunt circuit P of the HTS section S0 is configured as a forward diode. The forward diode may be provided as two forward diodes connected in series with each other as in FIG. 3, may be provided as one forward diode, or may be provided as three or more forward diodes connected in series with each other. Alternatively, the shunt circuit P of the HTS section S0 may have a configuration in which one forward diode and an electric resistance (resistor) are connected in series with each other, or may have a configuration in which an electric resistance (resistor) is connected in series with two, three, or more forward diodes connected in series with each other.

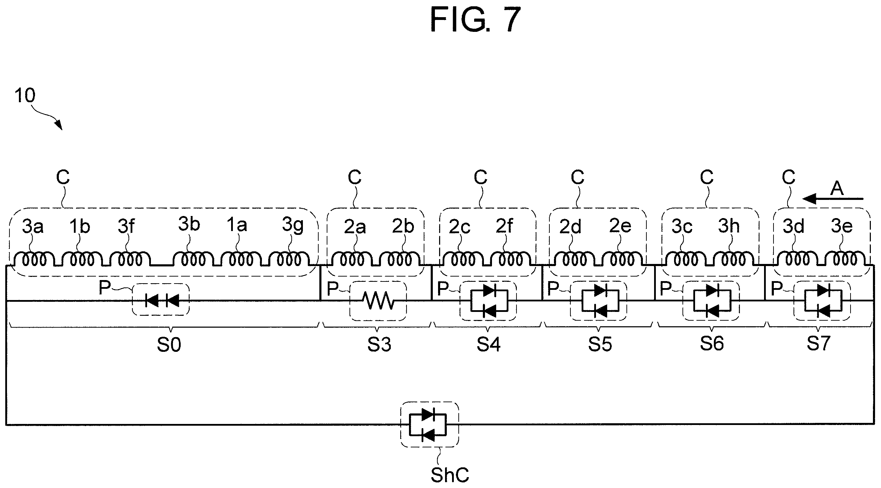

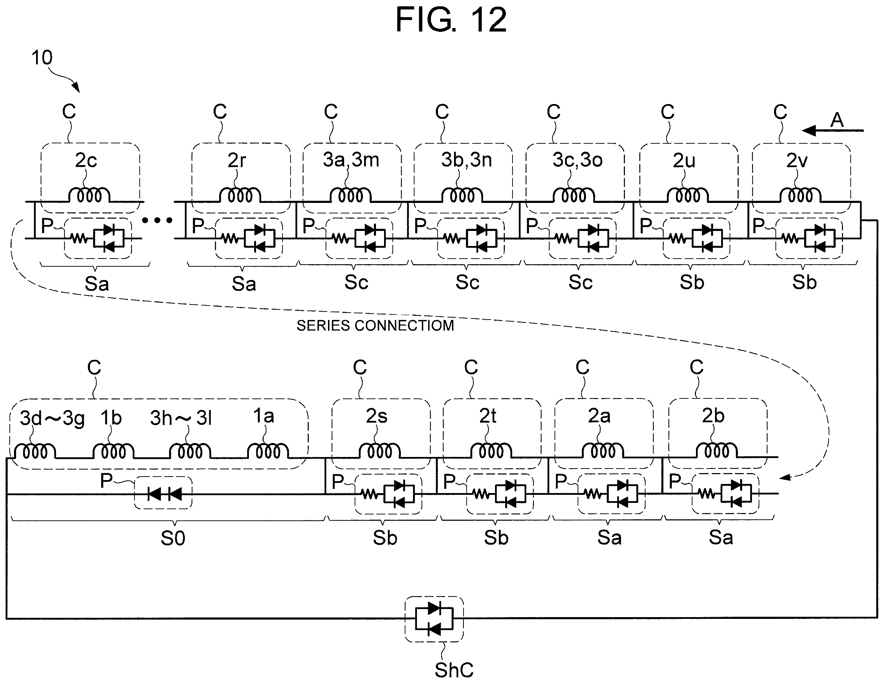

Note that in FIG. 6 (and FIGS. 7 and 12 to be described below), the shunt circuit P of the section (the LTS section S3 in FIG. 6) including the coil made of Nb₃Sn as a superconductor in the coil portion C may be configured as a forward diode. As a result, an increase in the induced current of this section is suppressed, and thus, an increase in the induced current in the HTS section can be also suppressed.

In the second embodiment, in the example of FIG. 6, the LTS sub-coils 3c, 3h, 3d, and 3e are included in the one HTS section S6, but the number of coils included in one section may be changed as appropriate. For example, as illustrated in FIG. 7, the HTS section S6 may include the LTS sub-coils 3c and 3h, and an additional HTS section S7 may include the LTS sub-coils 3d and 3e. The other points of the configuration in FIG. 7 are the same as those in FIG. 6.

In the second embodiment, in the LTS section S3 including the specific LTS main coils 2a and 2b made of Nb₃Sn as a superconductor in the coil portion C, the shunt circuit P may be configured as an electric resistance. In the second embodiment, a superconductor forming each of the other LTS main coils 2c to 2f and the LTS sub-coils 3a to 3h may be NbTi, and a superconductor forming each of the HTS main coils 1a and 1b may be Bi₂Sr₂Ca₂Cu₃Oₓ (Bi2223) or REBa₂Cu₃Oₓ (REBCO).

### (Advantageous Effects of Second Embodiment)

According to the second embodiment, the following advantageous effects (5) and (6) can be further achieved in addition to the above-described advantageous effects (1) to (4) in the first embodiment.

(5) The section S0 is configured as integration of the HTS sections S1 and S2 in the first embodiment, and the shunt circuit P of the HTS section S0 is configured as the forward diode. As a result, an increase in the induced current flowing to the HTS section S0 can be suppressed.

(6) The shunt circuit P of the LTS section S3 including the specific LTS main coils 2a and 2b made of Nb₃Sn having a high temperature margin in the coil portion C is configured to include an electric resistance. As a result, when the specific LTS main coil 2a or 2b quenches, a current decrease rate of the LTS section S3, i.e., a current decrease rate of the LTS main coil 2a or 2b can be slowed down. For this reason, a current increase in the combination coil in the HTS section S0 due to the electromagnetic induction based on this current decrease can be suppressed, and thus, an increase in the current of (the HTS main coil) can be suppressed.

### (Calculation Results by Electro-Thermal Coupled Analysis Simulation)

### <In Case of Comparative Example>

Concerning the conventional NMR superconducting magnet device illustrated in FIG. 1, the calculation using the electro-thermal coupled analysis has been performed for a case where the coil LM in the section S1 quenches during the operation at 1,060 MHz.

This electro-thermal coupled analysis simulation was performed for each coil in FIG. 1 under the following conditions.

The coil HM and the coil LM in each of the sections S1 and S2 are respectively made of Bi2223 and NbTi.

Each coil LM in the section S3 is made of Nb₃Sn.

In each of the sections S4 to S6, the coils LM and LC are made of NbTi.

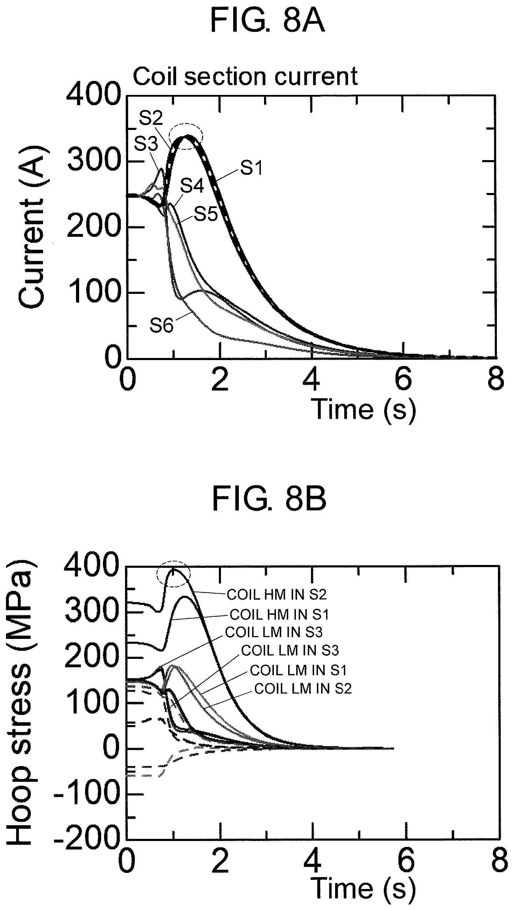

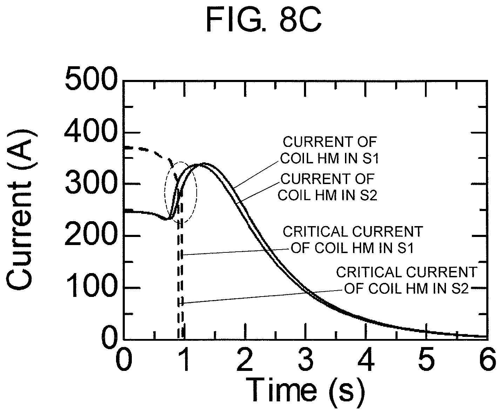

FIGS. 8A to 8C illustrate calculation results of the electro-thermal coupled analysis. In FIG. 8A, the vertical axis indicates the current flowing in each of the sections S1 to S6. In FIG. 8B, the vertical axis indicates the hoop stress generated in each the coil (the dashed curves in FIG. 8B indicate the hoop stresses of the other coils that are not particularly designated in FIG. 8B). In FIG. 8C, the vertical axis indicates the current of each the coil HM along with the critical current. In FIGS. 8A to 8C, the horizontal axis indicates an elapsed time from a time point at which the coil LM in the section S1 quenches.

In the case of FIG. 1, when the quench occurs, the current in the sections S1 and S2 including the main coils HM made of the high-temperature superconductor reaches 340 A from the initial current 247A so that the hoop stress reaches 396 MPa in the sections S1 and S2, as indicated in the parts surrounded by the broken lines in FIGS. 8A and 8B. In this manner, the current and hoop stress excessively increase, and thus, the main coil HM may be burned out and mechanically damaged.

Concerning the excessive current increase, the current of the main coils HM made of the high-temperature superconductor in the sections S1 and S2 exceeds the critical current as indicated in the part surrounded by the broken line in FIG. 8C, and thus, the main coils HM may quench to be burned out.

### <In Case of Second Embodiment>

Concerning the NMR superconducting magnet device illustrated in FIG. 7, the calculation using the electro-thermal coupled analysis was performed for a case where the LTS main coil 2c in the LTS section S4 quenches during the operation at 1,060 MHz.

This electro-thermal coupled analysis has been performed for each coil in FIG. 7 under the following conditions.

The HTS main coils 1a and 1b are made of Bi2223.

The LTS main coils 2a and 2b are made of Nb₃Sn.

The LTS main coils 2c to 2f and the LTS sub-coils 3a to 3h are made of NbTi.

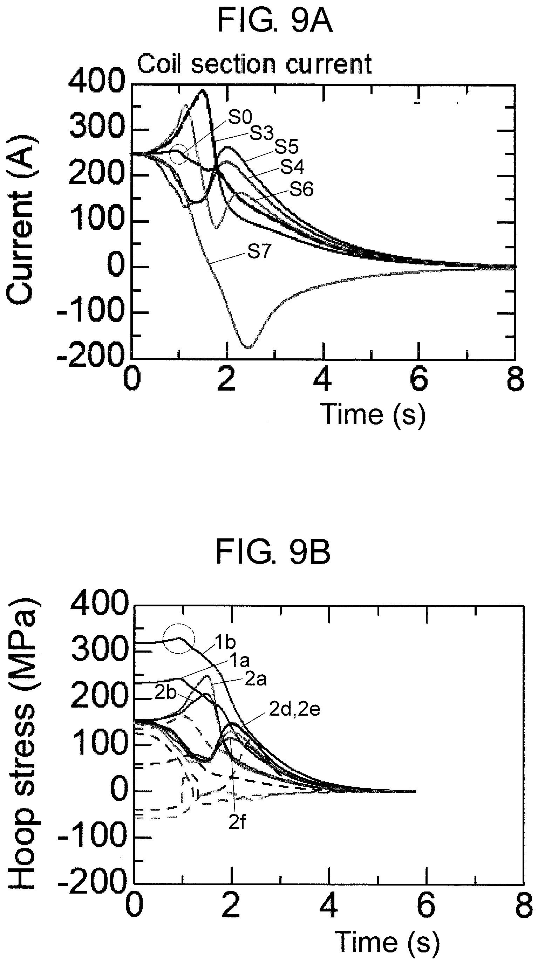

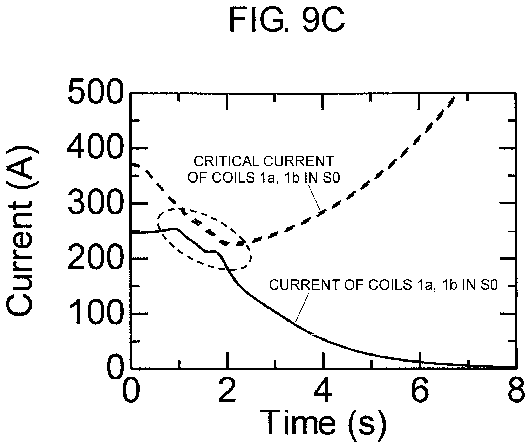

FIGS. 9A to 9C illustrate calculation results of the electro-thermal coupled analysis. In FIG. 9A, the vertical axis indicates the current flowing in each of the HTS sections S0 and S3 to S7. In FIG. 9B, the vertical axis indicates the hoop stress generated in each coil. In FIG. 9B, the signs such as 1a and 1b designate the hoop stresses of the coils of the respective signs, and the dashed curves indicate the hoop stresses of the other coils that are not particularly designated by the signs. In FIG. 9C, the vertical axis indicates the current of the HTS main coils 1a and 1b in the HTS section S0 along with the critical current. In FIGS. 9A to 9C, the horizontal axis indicates an elapsed time from a time point at which the LTS main coil 2c in the LTS section S4 quenches.

In the case of FIG. 7, when the quench occurs, the maximum value of the current in the HTS section S0 including the HTS main coils 1a and 1b made of the high-temperature superconductor is suppressed to 260 A so that the maximum value of the hoop stress can be suppressed to 330 MPa, as indicated in the parts surrounded by the broken lines in FIGS. 9A and 9B. In this manner, the maximum values of the current and hoop stress are suppressed.

Further, in the case of FIG. 7, when the quench occurs, the current of the HTS main coils 1a and 1b made of the high-temperature superconductor in the HTS section S0 does not reach the critical current, as indicated in the parts surrounded by the broken line in FIG. 9C, and thus, the quench of the HTS main coils 1a and 1b can be avoided. Although not illustrated, the temperature and voltage of each coil also stay within allowable ranges.

### (Experiment and Simulation)

Concerning the NMR superconducting magnet device illustrated in FIG. 7, the experiment and the electro-thermal coupled analysis simulation was performed for a case where the coils 2c to 2f and 3a to 3h made of NbTi quench successively with respect to a reference time point during the operation at 600 MHz.

This experiment and simulation were performed on each coil in FIG. 7 under the following conditions.

The HTS main coils 1a and 1b are made of Bi2223.

The LTS main coils 2a and 2b are made of Nb₃Sn.

The LTS main coils 2c to 2f and the LTS sub-coils 3a to 3h are made of NbTi.

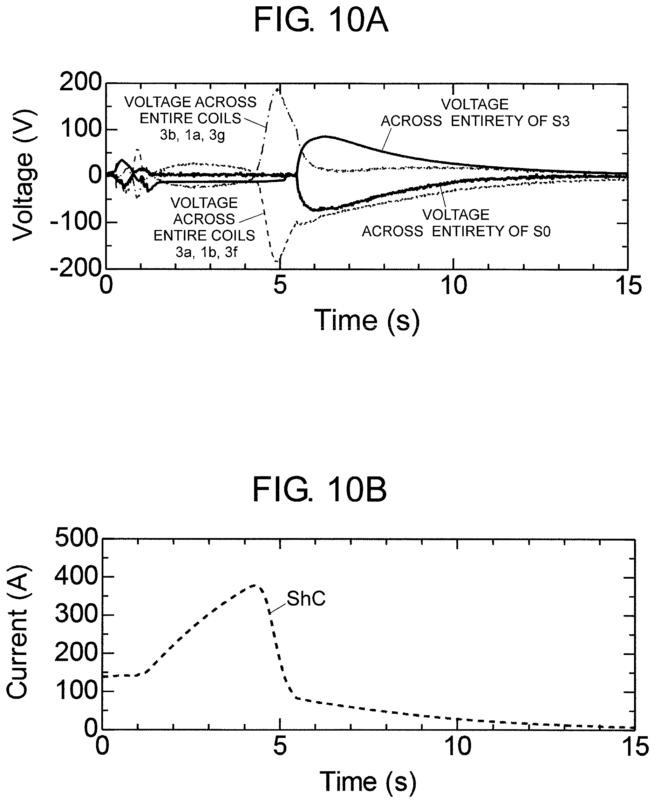

The results of the experiment are illustrated in FIGS. 10A and 10B. In FIG. 10A, the vertical axis indicates the voltage across the entire HTS section S0, the voltage across the entire LTS section S3, the voltage across the entire successive coils 3a, 1b, and 3f in the HTS section S0, and the voltage across the entire successive coils 3b, 1a, and 3g in the HTS section S0. In FIG. 10B, the vertical axis indicates the current of the short circuit ShC surrounded by the broken line indicated by the sign ShC in FIG. 7. In FIGS. 10A and 10B, the horizontal axis indicates an elapsed time from the above reference time point as an original point.

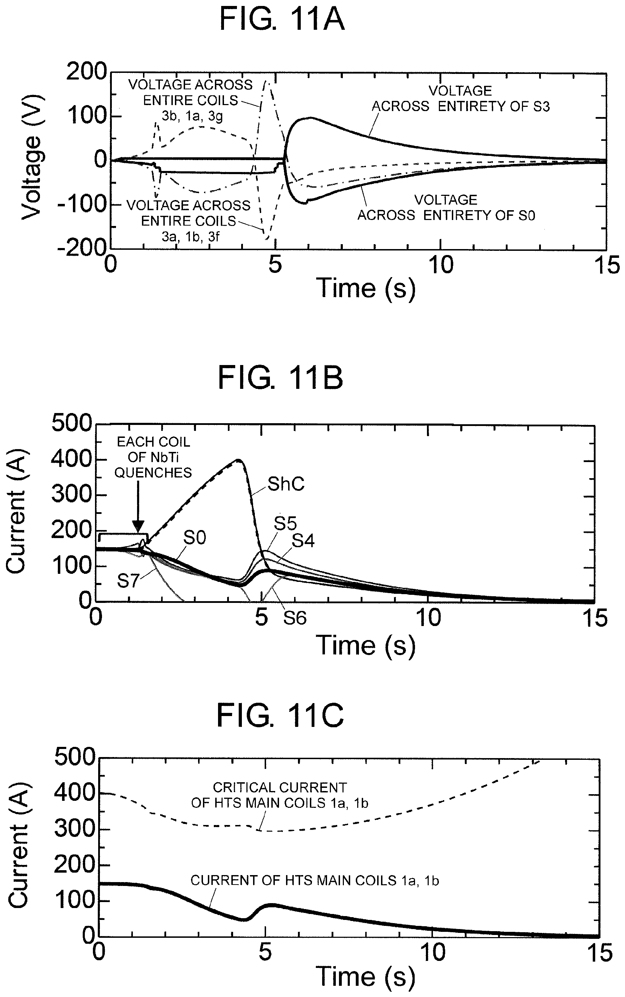

The results of the simulation are illustrated in FIGS. 11A to 11C. In FIG. 11A, the vertical axis indicates the voltage across the entire HTS section S0, the voltage across the entire section S3, the voltage across the entire successive coils 3a, 1b, and 3f in the HTS section S0, and the voltage across the entire successive coils 3b, 1a, and 3g in the HTS section S0. In FIG. 11B, the vertical axis indicates the current of each of the sections S0 and S4 to S7 and the short circuit ShC in FIG. 7. In FIG. 11C, the vertical axis indicates the current of the HTS main coils 1a and 1b (the HTS section S0) along with the critical current. In FIGS. 11A to 11C, the horizontal axis indicates an elapsed time from the above-described reference time point as an original point.

The consistent results are obtained in the experiment and simulation. When each of the coils 2c to 2f and 3a to 3h made of NbTi immediately quenches within 1.5 seconds from the reference time point (the original point of the horizontal axis), the LTS main coils 2a and 2b made of Nb₃Sn quench at an elapsed time point of approximately 4.5 seconds. After that, the current of the LTS main coils 2a and 2b immediately decreases, but the HTS main coils 1a and 1b do not quench because of the weak magnetic coupling of the combination coils 3a, 3f, 3b, and 3g with the HTS main coils 1a and 1b and the LTS main coils 2a and 2b (of which current corresponds to the current of the section S3 in FIG. 9A) made of Nb₃Sn of which current changes largely when the quench occurs. Thus, each of the experiment and the simulation demonstrates the effectiveness of the present embodiment.

### [Third Embodiment]

Hereinafter, the superconducting magnet device 10 according to the third embodiment of the present invention is described. In the third embodiment, the matters that are not described below may be the same as those in the second embodiment (and the first embodiment).

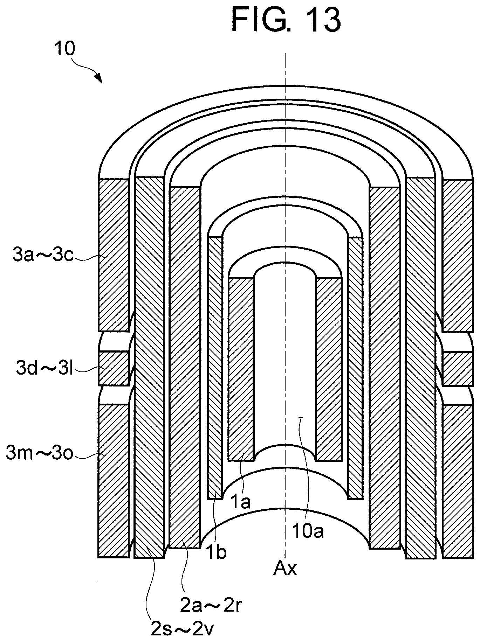

FIG. 12 is an example of a circuit diagram illustrating the superconducting magnet device 10 according to the third embodiment of the present invention. In FIG. 12, each of LTS sections is indicated by the sign Sa, Sb, or Sc as described below. FIG. 13 illustrates an example of a three-dimensional positional relation between a plurality of superconducting coils (the plurality of superconducting coils 1a, 1b, 2a to 2v, and 3a to 3o illustrated in FIG. 12) constituting the superconducting magnet device 10. In other words, FIG. 13 is a schematic perspective diagram illustrating an example of a cross section of the superconducting magnet device 10. FIG. 13 may be an example of a case where the superconducting magnet device 10 according to the third embodiment is used in NMR.

In the example of FIGS. 12 and 13, a high-temperature superconductor forming the HTS main coil 1a is REBCO. The term "REBCO" indicates a superconductor expressed by REBa₂Cu₃Oₓ. Here, "RE" indicates a rare earth element such as yttrium, gadolinium, and europium, for example. In the example of FIGS. 12 and 13, a high-temperature superconductor forming the HTS main coil 1b is Bi₂Sr₂Ca₂Cu₃Oₓ (Bi2223), a low-temperature superconductor forming each of the LTS main coils 2a to 2r as an example of the specific LTS main coil is Nb₃Sn, and a high-temperature superconductor forming each of the LTS main coils 2s to 2v and each of the LTS sub-coils 3a to 3o is NbTi.

As illustrated in FIG. 13, among the plurality of superconducting coils constituting the superconducting magnet device 10, the HTS main coil 1a, the HTS main coil 1b, the LTS main coils 2a to 2r, and the LTS main coils 2s to 2v are arranged in this order from a radial-direction inner side to a radial-direction outer side. The plurality of LTS main coils 2a to 2r are arranged in this order from a radial-direction inner side to a radial-direction outer side, and the same applies to the plurality of LTS main coils 2s to 2v.

A set of the LTS sub-coils 3a to 3c, a set of the LTS sub-coils 3d to 31, and a set of the LTS sub-coils 3m to 3o are provided such that these set are arranged in this order in the axial direction, on a radial-direction outer side of the LTS main coil 2v. The LTS sub-coils 3a to 3c are arranged in this order from a radial-direction inner side to a radial-direction outer side. Similarly, the LTS sub-coils 3d to 31 are arranged in this order from a radial-direction inner side to a radial-direction outer side, and the LTS sub-coils 3m to 3o are arranged in this order from a radial-direction inner side to a radial-direction outer side.

As in FIG. 12, the plurality of LTS sub-coils 3d to 3g and 3h to 31 (an example of the combination coil of the present invention) having the negative polarity may be included in the HTS section S0. In FIG. 12, in the coil portion C of the HTS section S0, the LTS sub-coils 3d to 3g, the HTS coil 1b, the LTS sub-coils 3h to 31, and the HTS coil 1a are connected in series with each other in this order in the series connection from a downstream side to an upstream side of the current. The four LTS sub-coils 3d to 3g are connected in series with each other in this order, and the same applies to the LTS sub-coils 3h to 31.

In the example of FIG. 12, each of the LTS sections Sa includes one of the specific LTS main coils 2a to 2r made of Nb₃Sn, each of the LTS sections Sb includes one of the LTS main coils 2s to 2v made of NbTi, and each of the LTS sections Sc includes the two LTS sub-coils 3a and 3m connected in series with each other, the two LTS sub-coils 3b and 3n connected in series with each other, or the two LTS sub-coils 3c and 3o connected in series with each other.

In the third embodiment, as described above, the coil portion C of the HTS section S0 includes the LTS sub-coils 3d to 3g and 3h to 31 having the negative polarity as the combination coils. In other words, the mutual inductance between each of the combination coils 3d to 3g and 3h to 3l and each of the LTS main coils 2a to 2v has a negative value. Among the plurality of LTS sub-coils 3a to 3o constituting the superconducting magnet device 10, each of the plurality of LTS sub-coils 3d to 3g and 3h to 31 as the combination coils has the number of coil turns smaller than that of each of the plurality of LTS sub-coils 3a to 3c and 3m to 3o that are not the combination coils. As a result, the magnetic coupling (mutual inductance) between each of the combination coils 3d to 3g and 3h to 31 and each of the specific LTS main coils 2a to 2r (and the other LTS main coils 2s to 2v) can be further reduced.

### (Advantageous Effects of Third Embodiment)

According to the third embodiment, the following effect (7) can be further achieved in addition to the above-described advantageous effects (1) to (6) of the first and second embodiments.

(7) For the above-described advantageous effect (3), the HTS section S0 includes the plurality of combination coils whose polarity is negative. In other words, the HTS section S0 includes the plurality of combination coils having the negative mutual inductance with each of the LTS main coils including the specific LTS main coils. With this configuration, when the LTS main coil is quenched, the current of the plurality of combination coils in the HTS section S0 decreases due to the negative electromagnetic induction based on the current decrease in the quenched LTS main coil. As a result, the increase in the current of the HTS coil in the HTS section can be further suppressed, and, for example, the propagation of the quench from the LTS main coil allows the current of the HTS coil to substantially monotonically decrease and thus reach a value of zero without increasing.

### (Calculation Results by Electro-Thermal Coupled Analysis Simulation)

Concerning the NMR superconducting magnet device illustrated in FIG. 12, the calculation using the electro-thermal coupled analysis was performed for a case where the quench occurs from the innermost LTS main coil 2a of the coils made of Nb₃Sn during the operation at 1.3 GHz. In the electro-thermal coupled analysis, the materials of each coil in FIG. 12 are the same as those described above.

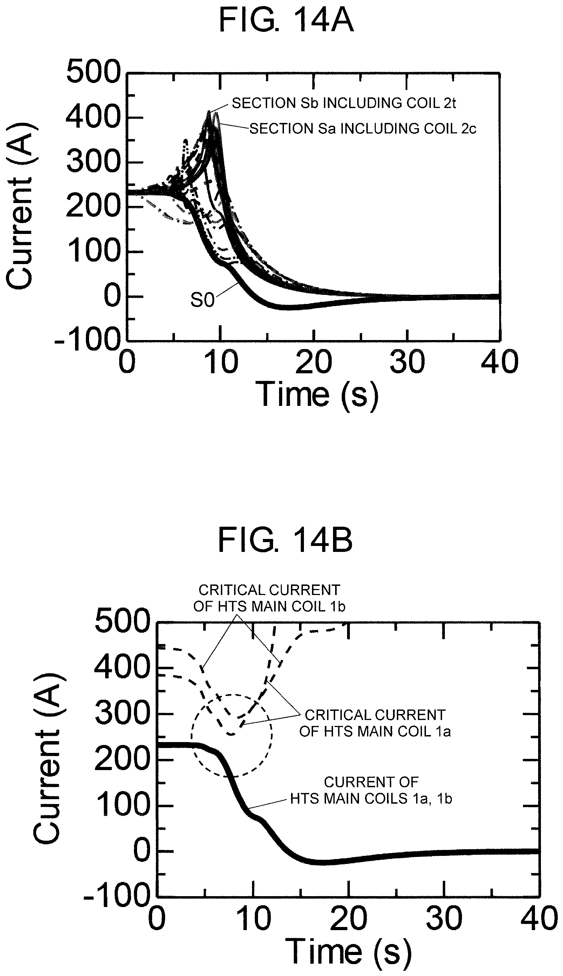

FIGS. 14A and 14B illustrate calculation results of the electro-thermal coupled analysis. In FIG. 14A, the vertical axis indicates the current of the HTS section S0 expressed with the bold curve (the curve designated by the sign S0), and the current of each of the other sections expressed with the other curves. In FIG. 14B, the vertical axis indicates the current of the HTS section S0 along with the critical current of each of the HTS main coils 1a and 1b. In FIGS. 14A and 14B, the horizontal axis indicates an elapsed time from a time point at which the LTS main coil 2a quenches.

As illustrated in FIG. 14A, the current of each of the sections other than the HTS section S0 greatly fluctuates, but the current of the HTS section S0 monotonically decreases because of the weak magnetic coupling between each of the combination coils 3d to 3g and 3h to 31 of the HTS main coils 1a and 1b and each of the coils (the LTS main coil 2c and the like made of Nb₃Sn) of which current largely changes.

As indicated in the part surrounded by the broken line in FIG. 14B, the current of the HTS main coils 1a and 1b made of the high-temperature superconductor in the HTS section S0 does not reach the critical current, and thus, the quench of the HTS main coils 1a and 1b can be avoided. Further, although not illustrated, the hoop stress, the temperature, and the voltage of each coil also stay within an allowable ranges.

### [Fourth Embodiment]

Hereinafter, the superconducting magnet device 10 according to the fourth embodiment of the present invention is described. In the fourth embodiment, the matters that are not described below may be the same as those in the third embodiment (and the first and second embodiments).

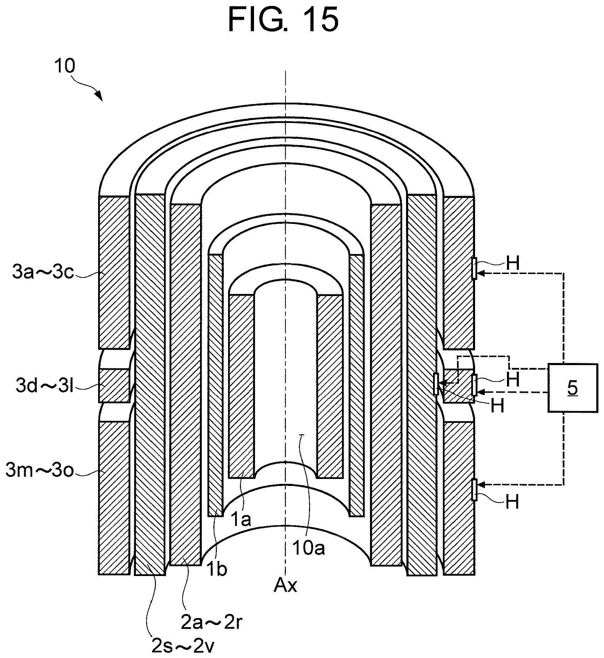

FIG. 15 illustrates an example of a three-dimensional positional relation between a plurality of superconducting coils (the plurality of superconducting coils 1a, 1b, 2a to 2v, and 3a to 3o illustrated in FIG. 12) constituting the superconducting magnet device 10. A circuit diagram for the plurality of superconducting coils constituting the superconducting magnet device 10 according to the fourth embodiment may be the same as the circuit diagram in FIG. 12 described in the third embodiment. The example illustrated in FIG. 15 may be a configuration for a case where the superconducting magnet device 10 according to the fourth embodiment is used in NMR.

The superconducting magnet device 10 according to the fourth embodiment includes heaters H and a control device 5.

The heater H is provided for each of the LTS sub-coils 3d to 3g and 3h to 3l (an example of combination coils) in the HTS section S0. In addition to this or instead of this, the heater H may be provided for each of the LTS main coils 2s to 2v made of NbTi and for each of the LTS sub-coils 3a to 3c and 3m to 3o that are arranged in the sections other than the HTS section S0 and are made of NbTi. For example, the heater H is provided at the axial-direction center of each of the outer peripheral surfaces of the plurality of LTS main coils 2s to 2v and the plurality of LTS sub-coils 3a to 3c and 3m to 3o. FIG. 15 illustrates only the heaters provided in a part of the LTS main coils and a part of the LTS sub-coils.

The control device 5 measures, for each of the plurality of sections S0, Sa, Sb, and Sc constituting the superconducting magnet device 10 (alternatively, for the predetermined one LTS section or for each of the predetermined plurality of LTS sections), a potential difference between both ends of the section. In the example of FIGS. 15 and 12, the control device 5 measures the potential difference between both ends of the HTS section S0, the potential difference between both ends of each of the plurality of LTS sections Sa, the potential difference between both ends of each of the plurality of LTS sections Sb, and the potential difference between both ends of each of the plurality of LTS sections Sc. The control device 5 measures these potential differences, and, when the value of one of the potential differences exceeds a predetermined threshold value, activates each of the heaters H. As a result, each of the LTS main coils and the LTS sub-coils that are made of NbTi is heated by the corresponding heater H, and is thereby quenched.

The control device 5 may measure a potential difference between both ends of the entirety of a combination of the plurality of sections S0, Sa, Sb, and Sc constituting the superconducting magnet device 10, and may activate each of the heaters H when the measured value of the potential difference exceeds a predetermined threshold value.

### (Advantageous Effects of Fourth Embodiment)

According to the fourth embodiment, the following advantageous effects (8) and (9) can be further achieved in addition to the above-described advantageous effects (1) to (7) of the first to third embodiments.

(8) When the quench occurs in the LTS section, the combination coils in the HTS section are heated by the heaters H and are forcibly quenched. Thereby, the electric resistance occurs in the combination coils, thus enabling the current of the combination coils to be prevented from excessively increasing due to the electromagnetic induction during the propagation process of the quench. As a result, the current increase in the HTS main coil can be suppressed.

(9) Even when any of the LTS main coils and the LTS sub-coils constituting the superconducting magnet device 10 quenches, all of the LTS main coils and the LTS sub-coils made of NbTi are forcibly quenched by the heating of the heaters H. As a result, even when any of the LTS main coils and the LTS sub-coils quenches, the current change in the HTS main coils becomes a similar change. Therefore, even when the quench begins from any of the LTS main coils and the LTS sub-coils, the current increase in the HTS main coils can be reliably avoided to prevent the quench in the HTS main coils. For example, it becomes unnecessary to perform the simulation for a case where the quench begins from the superconducting coil, concerning each of a large number of the LTS main coils and a large number of the LTS sub-coils, and to design arrangement of a large number of the superconducting coils so as to suppress the current increase in the HTS coils, based on all the simulation results.

The present invention is not limited to the above-described first to fourth embodiments, and it is natural that various modifications can be made within the scope of the technical idea of the present invention. For example, the superconducting magnet device according to each of the first to fourth embodiments does not need to include all of a plurality of the above-described constituents, and may include only a part of a plurality of the above-described constituents. Further, to the extent that at least a part of the above-described problems can be solved or to the extent that at least a part of the effects described in the present specification can be achieved, one or more constituents described in claims and the present specification can be omitted, or any combination of a plurality of the constituents described in claims and the present specification can be made.

Furthermore, each of the above-described first to fourth embodiments may employ one or both of the following first and second modification examples. In this case, the matters that are not described below may be the same as those in the above, or may be appropriately modified.

### (First Modification Example)

The combination coil is the correction coil in the above description, but may also be the shield coil. The shield coil generates a magnetic field for suppressing the leakage of the magnetic field to the outside of the predetermined area (in the above examples, the internal space 10a) in which the magnetic field is generated by each of the HTS main coils and each of the LTS main coils.

In this case, when the plurality of superconducting coils (the plurality of superconducting coils including the HTS main coils, the LTS main coils, and the shield coils) constituting the superconducting magnet device 10 have the common central axis Ax, the shield coil may be a coil arranged on a radial-direction outermost side among the plurality of superconducting coils. Thus, the shield coil have a large volume. For this reason, the shield coil generates large electric resistance when the shield coil quenches, and thus, the current of the HTS main coil in the same HTS section including the shield coil can be largely decreased. Both of the correction coil and the shield coil may be provided as the combination coils.

### (Second Modification Example)

The number of the HTS sections may be one, two, or three or more. The number of the combination coils included in the coil portion C of the one HTS section may be one, or may be two or more (e.g., the number different from that in the case of each of the drawings).

The number of the LTS sections may be one, or may be two or more. The number of the LTS coils (the LTS main coils and the LTS sub-coils) included in the coil portion C of the one LTS section may be one, or may be two or more.

The present application is based upon and claims the benefit of priority from Japanese Patent Application No. 2025-080230 filed on May 13, 2025, and Japanese Patent Application No. 2025-198314 filed on November 19, 2025, the entire contents of both of which are incorporated herein by reference.

### [Reference Signs List]

1, 1a, 1b HTS main coil
2, 2a to 2f LTS main coil
3, 3a to 3h LTS sub-coil (correction coil)
5 control device
10 superconducting magnet device
10a internal space
Ax central axis
C coil portion
H heater
S1 to S6 section
P shunt circuit

## Claims

1. A superconducting magnet device comprising a plurality of sections that are connected in series with each other, the plurality of sections each including a coil portion and a shunt circuit that are connected in parallel with each other, the coil portion including a superconducting coil,
the plurality of sections including:
one or more low-temperature superconductor (LTS) sections that each include an LTS main coil as the superconducting coil in the coil portion; and
a high-temperature superconductor (HTS) section that includes, as the superconducting coil in the coil portion, an HTS main coil and a combination coil connected in series with each other, wherein
the combination coil is an LTS sub-coil that generates a magnetic field for correcting a magnetic field generated by at least one of the HTS main coil and the LTS main coil, and
a specific LTS main coil that is the LTS main coil is arranged between the HTS main coil on an inner side and the combination coil on an outer side in a radial direction with respect to a central axis of the superconducting magnet device.

2. The superconducting magnet device according to claim 1, wherein
the specific LTS main coil is adjacent to the HTS main coil from an outer side of the HTS main coil in the radial direction.

3. The superconducting magnet device according to claim 1 or 2, wherein
a different LTS main coil is provided as the LTS main coil in addition to the specific LTS main coil, and
the specific LTS main coil has a critical temperature higher than that of the different LTS main coil.

4. The superconducting magnet device according to claim 3, wherein
the specific LTS main coil is made of Nb₃Sn that is a low-temperature superconductor.

5. The superconducting magnet device according to any one of claims 1 to 4, wherein
the HTS main coil and the LTS main coil generate a main magnetic field in a predetermined area, and
at least one of a correction coil that generates a magnetic field for increasing uniformity of a magnetic field in the predetermined area and a shield coil that generates a magnetic field for suppressing leakage of the magnetic field to an outside of the predetermined area is provided as the LTS sub-coil.

6. The superconducting magnet device according to any one of claims 1 to 5, wherein
a mutual inductance between the combination coil and the specific LTS main coil has a negative value.

7. The superconducting magnet device according to any one of claims 1 to 6, wherein
two combination coils are each provided as the combination coil in the coil portion of the HTS section, and
one of the two combination coil, the HTS main coil, and another of the two combination coil are connected in series with each other in this order in the coil portion of the HTS section.

8. The superconducting magnet device according to claim 4, wherein
the different LTS main coil is made of NbTi that is the low-temperature superconductor.

9. The superconducting magnet device according to any one of claims 1 to 8, wherein
the shunt circuit of the HTS section is configured as a forward diode.

10. The superconducting magnet device according to claim 3 or 4, wherein
the one or more LTS sections include an LTS section including the specific LTS main coil and an LTS section including the different LTS main coil, and
the shunt circuit of the LTS section including the specific LTS main coil is configured as an electric resistance.

11. The superconducting magnet device according to any one of claims 1 to 8, further comprising:
a heater that heats the combination coil in the HTS section; and
a control device that activates the heater when detecting quench in any of the plurality of sections.

12. The superconducting magnet device according to claim 3 or 4, wherein
a plurality of LTS main coils are each provided as the different LTS main coil, and
the superconducting magnet device further comprises:
heaters provided for the plurality of LTS main coils such that each of the plurality of LTS main coils can be heated by corresponding one of the heaters; and
a control device that activates the heaters when detecting quench in any of the plurality of sections.
